# EUROPEAN PATENT APPLICATION

(11) **EP 1 496 728 A1**
(43) Date of publication of application: **12.01.2005**
(21) Application number: 04076873.1
(22) Date of filing: 29.06.2004
(51) Int. Cl.: H05K 1/02

(54) **Circuit assemby having compliant substrate stuctures for mounting circuit devices**

(30) Priority: 10.07.2003 US 616611
(71) Applicant: Delphi Technologies, Inc., Troy, MI 48007 (US)
(72) Inventor: Stillabower, Morris D., Tipton, IN 46072-9111 (US)
(74) Representative: Denton, Michael John

(57) **Abstract**

A circuit assembly (10) comprising a substrate (12) formed to have one or more apertures (14,28) that define one or more compliant members (20) in the substrate (12), and to which a circuit device (18) can be attached so as to reduce thermally-induced stresses in the device (18) and in solder joints (19) securing the device (18) to the substrate (12). The compliant members (20) are sufficiently compliant to permit relatively large surface-mount devices (18) to be attached to an organic substrate (12) without sacrificing reliability.

## Description

### TECHNICAL FIELD

The present invention generally relates to substrates on which circuit devices are mounted. More particularly, this invention relates to a circuit assembly having a substrate equipped with one or more compliant structures to which a circuit device can be attached so as to reduce thermally-induced stresses in the device and in the solder joints that secure the device to the substrate.

### BACKGROUND OF THE INVENTION

Surface-mount technology (SMT) offers the advantages of increased reliability and lower manufacturing costs. Surface-mount devices (SMD) used in SMT processes are available in a range of chip or die (package or case form) sizes, with larger SMD's including the 2512 chips (about 6.5 x 3.25 mm), diodes, inductors, capacitors, resistors, varisters, etc. In many applications, large SMD's are desirable as they can replace numerous smaller SMD's (such as the 1206, 805 and 603 chips, etc.), thus reducing the need for capital equipment to place SMT components. Large SMD's also offer the possibility to replace traditional stick-lead components, which have a higher initial cost and higher cost associated with placement on a circuit board assembly.

Though having the above advantages, it is not conventional practice to place large SMD's on organic substrates (circuit boards) because of the significant mismatch in the coefficients of thermal expansion (CTE) between the organic materials used to form such substrates and the silicon or ceramic materials of SMT devices. Thermal cycling of a circuit assembly with continuous power cycles causes accumulative fatigue in the solder joints that attach a circuit device to its substrate, as well as within the body of the device and within the body of the substrate. This accumulative fatigue mechanism includes intergranular precipitation and alloy separation in the solder joints, which accelerates solder joint fatigue. The significant difference in thermal expansion between an SMD and substrate promotes solder joint fatigue, and can be sufficient to cause cracking of more brittle-bodied ceramic SMT components, such as surface-mount capacitors. In effect, the substrate materials are much stronger than the devices mounted to them. This disproportionate strength is also due to differences in mass moment of inertia of the devices and substrate, because SMD's present a much smaller moment of inertia in the stack-up with the substrate than does the substrate. The larger the component, the higher the stress and thus the likelihood for a shorter life from solder joint fatigue.

In view of the above, though their use is advantageous for a variety of reasons, large SMD's are not conventionally mounted to organic (e.g., FR4, Chem 1, Chem 3, etc.) circuit boards utilized in high temperature applications (e.g., temperatures of about 100°C and higher).

### BRIEF SUMMARY OF THE INVENTION

The present invention is directed to a circuit assembly comprising a substrate formed to have one or more apertures that define one or more compliant members in the substrate, and to which a circuit device can be attached so as to reduce thermally-induced stresses in the device and in solder joints securing the device to the substrate. The compliant members are sufficiently compliant to permit relatively large surface-mount devices to be attached to an organic substrate without sacrificing reliability.

Generally, the circuit assembly of this invention includes the substrate and a surface-mount device mounted thereto, multiple electrically-conductive pads present on at least one device attachment region of the substrate, and solder joints bonding the surface-mount device to the pads. The entire substrate, including the device attachment region and a second region outside the device attachment region, can be formed of a first material, e.g., an organic. The surface-mount device comprises a package (chip) formed of a material (e.g., silicon or a ceramic) having a lower coefficient of thermal expansion than the substrate material. At least one aperture is formed in the substrate, and is located and configured so as to cause the device attachment region (or at least a portion thereof) to be more compliant than the second region of the substrate, though both are formed of the same material. In this manner, the surface-mount device, mounted to the substrate through the pads located within a compliant region of the device attachment region, is subjected to lower thermally-induced stresses as compared to mounting the surface-mount device to the second (and less compliant) region of the substrate.

In view of the above, the present invention enables large surface-mount devices (SMD's) to be placed on organic substrates (circuit boards), though a significant CTE mismatch exists between the organic substrate and SMD. More particularly, the compliant region(s) to which the SMD is attached reduces thermally-induced stresses that lead to fatigue fracturing of the solder joints that attach the SMD to the substrate and can also lead to fatigue cracking of the SMD. Accordingly, the processing and packaging advantages associated with large SMD's can be achieved on organic (e.g., FR4, Chem 1, Chem 3, etc.) circuit boards, even when service temperatures are about 100°C or higher.

Other objects and advantages of this invention will be better appreciated from the following detailed description.

### BRIEF DESCRIPTION OF THE DRAWINGS

Figure 1 is a plan view of a region of a circuit board substrate showing a device attachment region defined between a pair of apertures in accordance with an embodiment of the present invention.
Figure 2 is a plan view of the substrate region depicted in Figure 1, after filling the apertures with a fill material and attaching an SMD to the device attachment region.
Figures 3 through 8, 10 and 11 are plan views of circuit board substrate regions showing device attachment regions defined with apertures in accordance with alternative embodiments of the present invention.
Figure 9 is a cross-sectional view of the substrate region depicted in Figure 8.

### DETAILED DESCRIPTION OF THE INVENTION

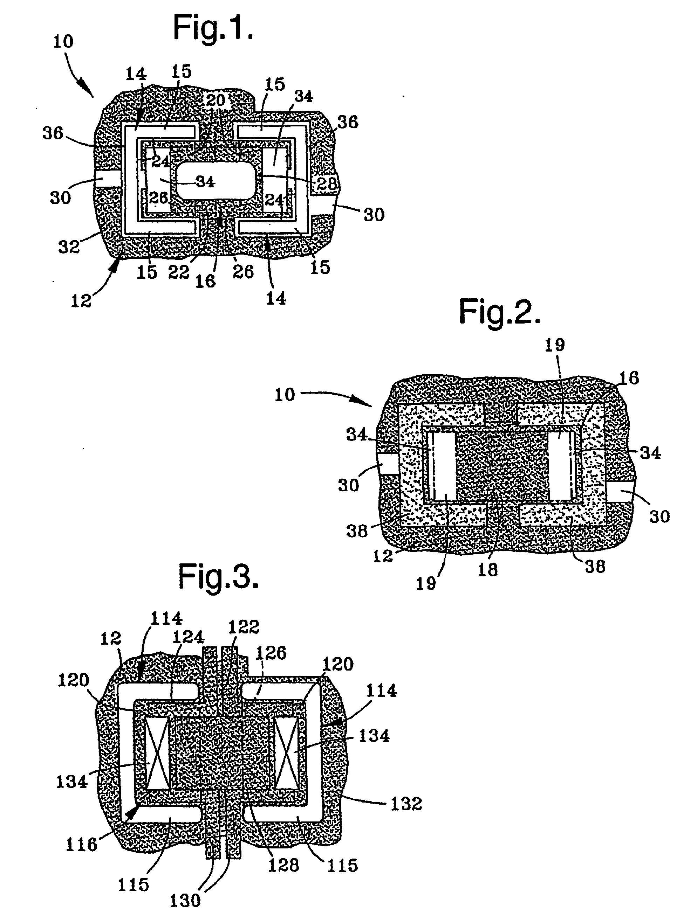

Figures 1 through 11 depict portions of a circuit assembly 10 with device attachment regions configured in accordance with various embodiments of the present invention, for the purpose of attaching surface-mount devices (SMD's) to a substrate, referred to herein as a circuit board 12. The SMD's can be of any type known or subsequently developed, though of particular interest to the invention are relatively large SMD's such as the 2512 chip (package or case form), with dimensions of about 6.5 x 3.25 mm. Furthermore, the circuit board 12 can be formed of a variety of materials, though of particular interest are circuit boards formed of organic materials, such as FR4, Chem 1, and Chem 2, which are generally glass-reinforced or woven fiberglass-reinforced epoxy resin laminate materials available from various commercial sources.

Figures 1 and 2 represent a first embodiment of this invention, in which a pair of substantially U-shaped slots (apertures) 14 with parallel sets of legs 15 are formed in the circuit board 12 by any suitable process, such as punching. As most readily seen in Figure 1, a device attachment region 16 is defined by and between the slots 14, in which an SMD 18 is attached to the circuit board 12 as shown in Figure 2. The device attachment region 16 comprises a pair of oppositely-disposed members 20 separated and cantilevered from a central region 22 of the attachment region 16. Three sides of each member 20 form a peripheral border 24 delineated by one of the slots 14, while the remaining side is generally a boundary 26 that separates the member 20 from the central region 22. As a result, each member 20 is more readily able to flex in the direction normal to the plane of the circuit board 12 than a region 32 of the circuit board 12 outside (e.g., immediately surrounding) the device attachment region 16. Depending on the width of the members 20 (transverse to the alignment direction of the slots 14) and the thickness of the circuit board 12, the members 20 can be significantly more compliant than the region 32 of the circuit board 12 immediately outside the attachment region 16.

Figure 1 also shows a rectangular-shaped central aperture 28 as being present in the central region 22 and longitudinally extending in opposite directions into the members 20. The central aperture 28 is preferably centered symmetrically within the device attachment region 16, so as to be equidistant in the longitudinal direction from each slot 14 and equidistant in the transverse direction from the legs 15 of each slot 14. The central aperture 28 further increases the compliance of the members 20, particularly by reducing the cross-sectional area of the board 12 at the boundary 26 of each member 20. The aperture 28 is between a pair of electrically-conductive bond pads 34 located on the members 20, to which the SMD 18 is physically and electrically attached with solder joints 19 in a conventional manner. The bond pads 34 are electrically coupled to the region 32 of the circuit board 12 with electrically-conductive runners 30, such as copper traces. As shown in Figure 1, the runners 30 approach the attachment region 16 from opposite directions, bifurcate and follow the outward edges 36 of the slots 14 to the inward edges of the slots 14 (defined by the borders 24 of the members 20), and then merge and continue inward toward the central region 22 until the pads 34 are encountered. The portions of the runners 30 along the edges of the slots 14 are preferably formed by plating the walls of the slots 14.

The dimensions of the features shown in Figure 1 can be varied, depending on the particular application and the size of the SMD 18. If the SMD 18 is a 2512 chip, suitable dimensions include: width of the slots - about 0.8 mm; transverse and longitudinal dimensions of the device attachment area 16 (between the slots 14) - about 4.2 x 7.9 mm; transverse and longitudinal dimensions of the central aperture 28 - about 2.0 x 4.0 mm; transverse and longitudinal dimensions of the central region 22 (between the boundaries 26) - about 4.2 x 2.1 mm. Those skilled in the art will appreciate that the size and number of bond pads 34 will depend on the particular size and type of SMD 18.

As noted above, Figure 2 shows the SMD 18 placed on the device attachment region 16 and attached to the bond pads 34, such that the central aperture 28 is directly beneath the SMD 18. According to an optional aspect of the invention, Figure 2 also shows the U-shaped slots 14 filled with a suitable fill material 38, such as a solder mask material or hole-filling material. The purpose of the fill material 38 is to stabilize the cantilevered members 20 and potentially tailor the compliance of the members 20.

Figures 3 through 11 depict additional configurations for device attachment regions in accordance with embodiments of this invention. In these Figures, consistent reference numbers are used to identify similar structures, but with a numerical prefix (1, 2, or 3, etc.) added to distinguish the particular embodiment from other embodiments of the invention.

In Figure 3, the transverse dimensions of the slots 114, device attachment region 116 and central aperture 128 have each been increased in proportion to their longitudinal dimensions, and runners 130 are routed between the slots 114 instead of along the edges of the slots 114. Otherwise, the embodiment of Figure 3 is generally identical to the embodiment of Figures 1 and 2.

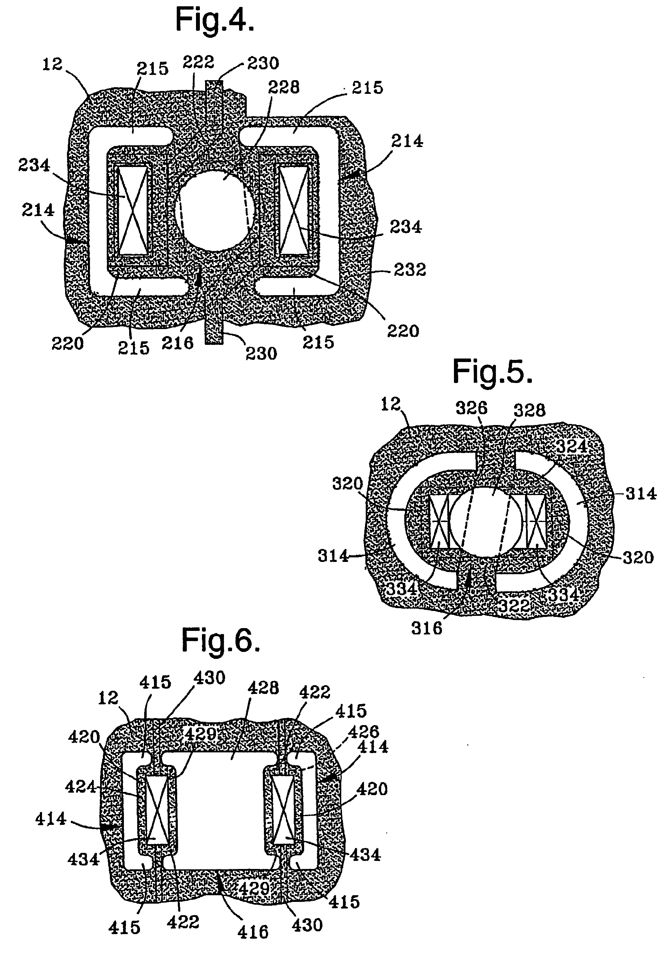

The embodiment of Figure 4 differs from that of Figure 3 by replacing the rectangular-shaped central aperture 128 with a circular-shaped central aperture 228, and by sizing each U-shaped slot 214 to have legs 215 that differ in length. In combination, the circular-shaped central aperture 228 and the legs 215 of different lengths render the bond pads 234 more accessible with the runners 230, which are again routed between the legs 215 instead of along the edges of the slots 214.

Figure 5 is similar to the embodiment of Figure 4, but differs by having slots 314 with a more arcuate C-shape, instead of the more rectilinear U-shape depicted in Figures 1 through 4. A benefit to the C-shaped slots 314 is that they consume less circuit board area than the U-shaped slots of previous embodiments.

Figure 6 depicts a configuration in which the size of the central aperture 428 is significantly larger than adjacent U-shaped slots 414, such that nearly the entire central region 422 is occupied by the aperture 528. In addition, to ensure adequate compliance of the members 420, the shape of the central aperture 428 has been altered to compensate for the relatively smaller size of the slots 414. More particularly, the slots 414 are substantially equal in shape and size but with relatively shorter legs 415 than in previous embodiments, and the central aperture 428 is significantly wider than the slots 414 in the direction in which the slots 414 and aperture 428 are aligned. Finally, the central aperture 428 defines two oppositely-disposed U-shaped edges 429 that face the slots 414, such that the central region 422 is effectively as compliant as the member 420. Consequently, this embodiment permits the bond pads 434 to straddle both the compliant members 420 and the central region 422.

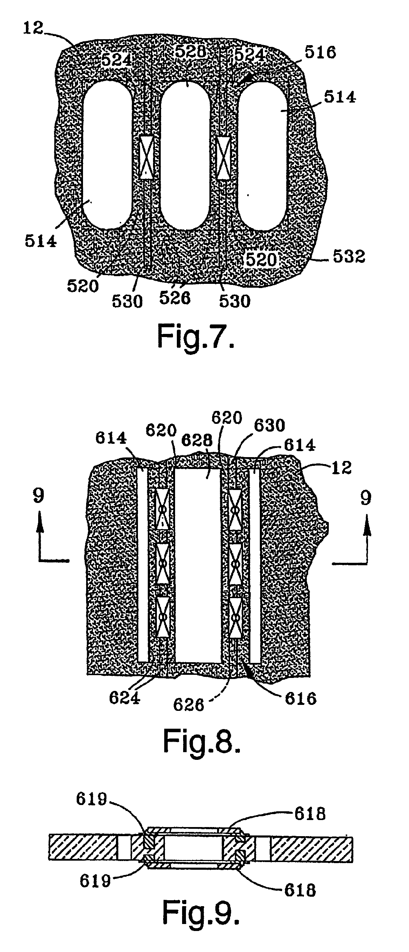

In Figure 7, two slots 514 and a central aperture 528 of substantially the same size and shape are aligned in a row. The slots 514 and aperture 528 are depicted as having an oval shape, oblong transverse to their direction of alignment. The device placement region 516 (effectively the area between the slots 514) comprises two compliant members 520 delineated by and between the central aperture 528 and each of the slots 514. As such, each compliant member 520 has opposing peripheral borders 524 delineated by the slots 514 and aperture 528, and opposing boundaries 526 that are not delineated by the slots 514 and aperture 528 so as to be contiguous with the remainder 532 of the circuit board 12 outside the device placement region 516. As such, the compliant members 520 are not cantilevered but instead are effectively bridges, and the central region of previous embodiments is essentially eliminated in the embodiment of Figure 7.

Figures 8 and 9 depict a similar embodiment to that of Figure 7, but with the slots 614 and aperture 628 being rectilinear instead of oval. Figure 9 also shows a pair of SMD's 618 attached with solder joints 619 to opposite surfaces of the circuit board 12.

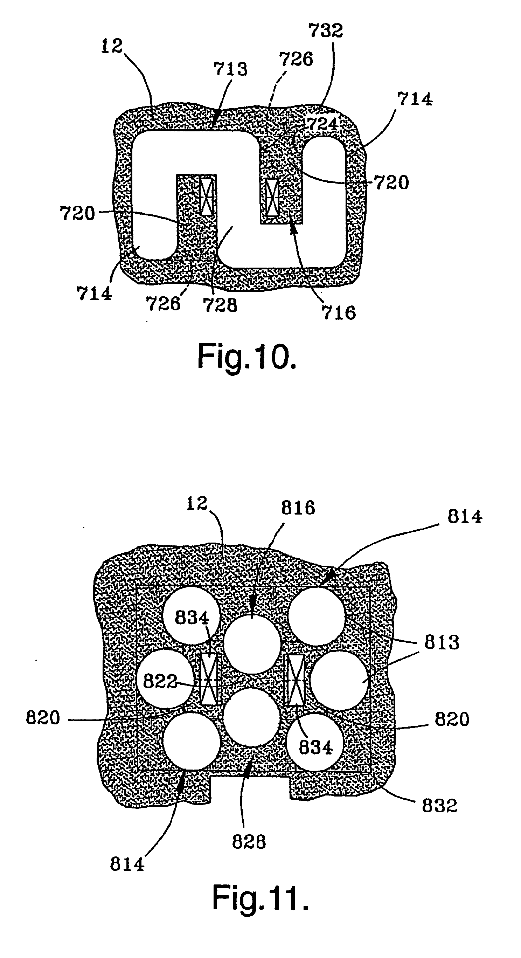

Figure 10 depicts an embodiment in which the three apertures 514 and 528 of Figure 7 are effectively interconnected to form a single continuous S-shaped aperture 713. The device placement region 716 is effectively the area between a pair of oppositely-disposed transverse portions 714 of the aperture 713. A central transverse portion 728 of the aperture 713 delineates a pair of compliant members 720 with each of two the transverse portions 714. Each of the compliant members 720 has peripheral borders 724 delineated on three sides by the aperture 713, and a boundary 726 that is not delineated by the aperture 713 and therefore contiguous with the remainder 732 of the circuit board 12. As such, the compliant members 720 are again cantilevered, in contrast to the bridge-type compliant members of Figures 7 through 9.

Finally, Figure 11 depicts an embodiment in which the three apertures of previous embodiments are replaced by multiple circular-shaped apertures 813. The device placement region 816 is effectively the area between a pair of oppositely-disposed sets 814 of aperture 813. A central set 828 of apertures 813 delineates a pair of compliant members 820 with each of two other sets 814 of apertures 813. While each apertures 813 is discrete, they are sufficiently close together to cause the compliant members 820 to be significantly more compliant than the remainder 832 of the circuit board 12 surrounding the device placement region 816 between the sets 814 of apertures 813. Each compliant member 820 is defined by borders delineated by the apertures 813, and further defined by boundaries formed by bridges between adjacent apertures 813. Though they consume more circuit board area as compared to previous embodiments, an advantage to the apertures 813 of this embodiment is that they can be readily formed by simple drilling or punching operations.

In an analytical investigation of the present invention, a three-dimensional finite element analysis (FEA) simulation was performed to assess the potential of this invention to improve the life expectancy of solder joints. The FEA simulation modeled an organic circuit board having a thickness of 1.6 mm, a standard 2512 SMD chip having length and thickness dimensions of 6.6 mm and 0.6 mm, bond pads with length and thickness dimensions of 0.6 mm and 0.0175 mm, and solder connections with a thickness dimension of 0.02 mm. The material properties of these components are summarized in the following Table 1.

**TABLE 1.**

| Chip | Modulus | 372,413 MPa |
|---|---|---|
| | Poison's ratio | 0.23 |
| | CTE | 5.6 ppm/°C |

| Board | Modulus | 24,400 MPa |
|---|---|---|
| | Poison's ratio | 0.26 |
| | CTE | 18 ppm/°C |

| Bond Pad | Modulus | 120,000 MPa |
|---|---|---|
| | Poison's ratio | 0.3636 |
| | CTE | 17 ppm/°C |

The analysis compared a conventional (slotless) circuit board to circuit boards with device attachment regions defined by slots and a central aperture in accordance with Figure 1, with dimensions summarized in Table 2.

**TABLE 2.**

| | DESIGN A | DESIGN B |
|---|---|---|
| Width of the U-shaped slots | 0.8 mm | 0.8 mm |
| Outer transverse dimension of each U-shaped slot | 6.5 mm | 5.0 mm |
| Outer longitudinal dimension (leg length) of each U-shaped slot | 3.7 mm | 3.7 mm |
| Combined outer longitudinal dimension of the U-shaped slots | 9.5 mm | 8.8 mm |
| Dimensions of the central aperture - Transverse x longitudinal | 3.0x4.0 mm | 2.0x4.0 mm |

The analysis employed a temperature profile based on a sixty-minute temperature cycle with fifteen-minute ramps and dwells using temperature extremes of -40°C and + 125°C. The results of this analysis are summarized in Table 3, with reported values being cycles completed before the occurrence of solder joint cracking ("failure"), with "nominal reports indicating the average Weibull number of cycles to "failure."

**TABLE 3.**

| | WORST CASE | BEST CASE | NOMINAL |
|---|---|---|---|
| Slotless circuit board | 1259 | 2481 | 1909 |
| Design A | 3967 | 7814 | 6011 |
| Design B | > 10,000 | > 10,000 | > 10,000 |

Consequently, the FEA simulation showed that a 2512 chip can exhibit a significantly extended life expectancy if mounted to an organic circuit board with slots configured in accordance with this invention, particular if the Design B dimensions are used.

In view of the above, it can be seen that the present invention provides a technique for modifying substrates to which SMD's are to be attached, by which the substrate includes stress-relieving compliant structures that reduce the deleterious stresses that arise from differences in CTE's within the circuit assembly, particularly the substrate and the SMD chip. The slots and/or apertures used to form the compliant structures also serves to better match the moment of inertia of the SMD with that of the modified substrate. By reducing the relative strength ratios of the SMD and substrate with compliant structures, solder joints that attach the SMD to the substrate will have less accumulative strain energy with each thermal cycle, and the resulting damage due to thermal fatigue will be proportionally decreased. Slots and apertures of a wide variety of sizes and shapes can be readily formed by existing circuit board processes, including drilling and punching. As such, the invention can be readily implemented at relatively low cost, while maintaining the same circuit functionality and reducing concerns for solder joint fatigue.

A significant advantage of the present invention is enabling the use of large SMD (e.g., 2512 chip, etc.), which under many circumstances will reduce the component count (i.e., one 2512 chip in place fifteen or more 0803 chips), simplify assembly processing, and reduce the number of component placement machines required for a particular circuit board assembly.

While the invention has been described in terms of a preferred embodiment, it is apparent that other forms could be adopted by one skilled in the art. Accordingly, the scope of the invention is to be limited only by the following claims.

## Claims

1. A circuit assembly (10) comprising a substrate (12) and a surface-mount device (18) mounted thereto, multiple electrically-conductive pads (34) present on at least one device attachment region (16) of the substrate (12), and solder joints (19) bonding the surface-mount device (18) to the pads (34), the at least one device attachment region (16) and a second region (32) of the substrate (12) being formed of a first material, the surface-mount device (18) comprising a package formed of a second material having a lower coefficient of thermal expansion than the first material, **characterized in that**:
the substrate (12) has at least one aperture (14,28) formed therein that is located and configured so as to cause at least a portion (20) of the at least one device attachment region (16) to be more compliant than the second region (32) of the substrate (12).

2. The circuit assembly (10) according to claim 1, **characterized in that** the at least one aperture (14,28) comprises first and second apertures (14), the first and second apertures (14) delineate first and second compliant members (20), respectively, within the at the least one device attachment region (16) of the substrate (12), and at least some of the pads (34) are located on the first and second compliant members (20).

3. The circuit assembly (10) according to claim 2, **characterized in that** each of the first and second apertures (14) is U-shaped in the plane of the substrate (12).

4. The circuit assembly (10) according to claim 2, **characterized in that** each of the first and second apertures (14) is C-shaped in the plane of the substrate (12).

5. The circuit assembly (10) according to claim 2, **characterized in that** the first and second compliant members (20) have peripheral borders (24) delineated by the first and second apertures (14), respectively, and each of the first and second compliant members (20) has a boundary (26) that is not delineated by the first and second apertures (14).

6. The circuit assembly (10) according to claim 5, **characterized in that** the boundaries (26) of the first and second compliant members (20) face each other so that a central region (22) of the at least one device attachment region (16) is between the first and second compliant members (20).

7. The circuit assembly (10) according to claim 6, further comprising a third aperture (28) in the central region (22) of the at least one device attachment region (16).

8. The circuit assembly (10) according to claim 7, **characterized in that** the third aperture (28) extends into each of the first and second compliant members (20) separated by the central region (22).

9. The circuit assembly (10) according to claim 7, **characterized in that** the third aperture (28) has a substantially rectilinear shape in the plane of the substrate (12).

10. The circuit assembly (10) according to claim 7, **characterized in that** the third aperture (28) has a substantially circular shape in the plane of the substrate (12).

11. The circuit assembly (10) according to claim 2, further comprising conductive runners (30) that electrically interconnect the pads (34) on the first and second compliant members (20) to the second region (32) of the substrate (12).

12. The circuit assembly (10) according to claim 11, **characterized in that** at least one of the conductive runners (30) extends along a surface of the substrate (12) between the first and second apertures (14).

13. The circuit assembly (10) according to claim 11, **characterized in that** at least one of the conductive runners (30) extends along an edge (24,36) of one of the first and second apertures (14).

14. The circuit assembly (10) according to claim 2, **characterized in that** the first and second apertures (14) are filled with an electrically-nonconductive material (38) that differs from the first and second materials.

15. The circuit assembly (10) according to claim 1, **characterized in that** the at least one aperture (14,28) comprises multiple apertures (813), a first set (814) of the multiple apertures (813) delineates a first compliant member (820) within the at the least one device attachment region (816) of the substrate (12), a second set (814) of the multiple apertures (813) delineates a second compliant member (820) within the at the least one device attachment region (816) of the substrate (12), and at least some of the pads (834) are located on the first and second compliant members (820).

16. The circuit assembly (10) according to claim 15, **characterized in that** each of the multiple apertures (813) is discrete and circular-shaped in the plane of the substrate (12).

17. The circuit assembly (10) according to claim 15, **characterized in that** a central region (822) is defined by and between the first and second compliant members (820) within the at least one device attachment region (816).

18. The circuit assembly (10) according to claim 17, further comprising at least one central aperture (828) in the central region (822) of the at least one device attachment region (816).

19. The circuit assembly (10) according to claim 1, **characterized in that** the at least one aperture (14,28) comprises at least three apertures (514,528) aligned in a row, first and second apertures (514,528) of the at least three apertures (514,528) are adjacent and delineate a first compliant member (520) therebetween within the at the least one device attachment region (516) of the substrate (12), the second aperture (528) and a third aperture (514) of the at least three apertures (514,528) are adjacent and delineate a second compliant member (520) therebetween within the at the least one device attachment region (516) of the substrate (12), and at least some of the pads (534) are located on the first and second compliant members (520).

20. The circuit assembly (10) according to claim 19, **characterized in that** each of the at least three apertures (514,528) is discrete and oblong-shaped in the plane of the substrate (12) and in a direction transverse to a direction in which the first, second and third apertures (514,528) are aligned.

21. The circuit assembly (10) according to claim 19, **characterized in that** each of the first and second compliant members (520) has opposing peripheral borders (524) delineated by the at least three apertures (514,528), and each of the first and second compliant members (520) has opposing boundaries (526) that are not delineated by the at least three apertures (514,528) so as to be contiguous with the second region (532) of the substrate (12).

22. The circuit assembly (10) according to claim 21, **characterized in that** the first and second compliant members (20) are separated by the second aperture (528).

23. The circuit assembly (10) according to claim 22, **characterized in that** the first, second and third apertures (514,528) are substantially equal in shape and size.

24. The circuit assembly (10) according to claim 22, **characterized in that** the first, second and third apertures (614,628) are substantially equal in shape, the first and second apertures (614) are substantially equal in size, and the third aperture (628) is wider than the first and second apertures (614) in a direction in which the first, second and third apertures (614,628) are aligned.

25. The circuit assembly (10) according to claim 22, **characterized in that** the first and second apertures (414) are U-shaped in the plane of the substrate (12) so that the peripheral borders (424) of the first and second compliant members (420) are U-shaped in the plane of the substrate (12) and the boundaries (426) of the first and second compliant members (420) face the third aperture (428), and the third aperture (428) has two oppositely-disposed U-shaped edges (429) facing the first and second apertures (414).

26. The circuit assembly (10) according to claim 25, **characterized in that** the first and second apertures (414) are substantially equal in shape and size, and the third aperture (428) is wider than the first and second apertures (414) in a direction in which the first, second and third apertures (414,428) are aligned.

27. The circuit assembly (10) according to claim 19, further comprising conductive runners (30) that electrically interconnect the pads (534) on the first and second compliant members (520) to the second region (532) of the substrate (12).

28. The circuit assembly (10) according to claim 1, **characterized in that** the at least one aperture (714,728) comprises an S-shaped aperture (713), first and second portions (714,728) of the S-shaped aperture (713) delineate a first compliant member (720) within the at the least one device attachment region (716) of the substrate (12), the second portion (728) and an adjacent third portion (714) of the S-shaped aperture (713) delineate a second compliant member (720) within the at the least one device attachment region (716) of the substrate (12), and at least some of the pads (734) are located on the first and second compliant members (720).

29. The circuit assembly (10) according to claim 28, **characterized in that** each of the first and second compliant members (720) has peripheral borders (724) delineated on three sides by the S-shaped aperture (713), and each of the first and second compliant members (720) has a boundary (726) that is not delineated by the S-shaped aperture (713) so as to be contiguous with the second region (732) of the substrate (12).

30. The circuit assembly (10) according to claim 29, **characterized in that** the first and second compliant members (720) are separated by the second portion (728) of the S-shaped aperture (713).
